# EUROPEAN PATENT SPECIFICATION

(11) **EP 2 332 176 B1**
(45) Date of publication and mention of the grant of the patent: **01.07.2020**
(21) Application number: 09776276.9
(22) Date of filing: 03.09.2009
(51) Int. Cl.: H01L 31/0352, H01L 31/18, H01L 31/0236, H01L 31/075, H01L 31/077

(54) **SOLAR CELL WITH FLEXIBLE CORRUGATED SUBSTRATE AND METHOD FOR THE PRODUCTION THEREOF**
SOLARZELLE MIT EINEM FLEXIBLEN GEWELLTEN SUBSTRAT UND VERFAHREN ZU DESSEN HERSTELLUNG
CELLULE SOLAIRE COMPRENANT UN SUBSTRAT ONDULE FLEXIBLE ET SON PROCEDE DE PRODUCTION

(30) Priority: 05.09.2008 EP 08163782
(43) Date of publication of application: 15.06.2011
(73) Proprietor: Flexucell ApS, 9750 Østervraa (DK)
(72) Inventor: LARSEN, Jens William, DK-9300 Dronninglund (DK); KIIL, Hans-Erik, DK-6200 Aabenraa (DK)
(74) Representative: Gregersen, Niels Henrik
(86) International application number: PCT/DK2009/050223
(87) International publication number: WO 2010/025734

(56) References cited:
- EP-A2- 0 334 330
- WO-A-2008/088570
- JP-A- 60 201 667
- JP-A- 2005 150 242
- JP-A- 2008 034 686
- US-A- 4 514 581
- US-A- 4 644 091
- US-A- 5 964 962
- US-A1- 2008 173 349
- US-A1- 2008 226 878
- US-B1- 6 291 761

## Description

### Field of the Invention

The present invention relates to a transducer in the form of a photo electric transducer of the type indicated in the preamble to claim 1.

### Background of the Invention

The expression transducer shall in connection with the present invention be understood as a generic expression for a device being able to transform one energy form to another energy form, by way of example solar light to electricity, or electricity to electromagnetic radiation, such as light.

Known solar cells usually have a relative small area on a relative stiff substrate, which thus may be an additional reason for the limitation of the practical area of use of solar cells.

US 6291761 B1 discloses a thin-film solar cell with a flexible substrate having grooves on the surface thereof. WO 2008/010205 A2 discloses a thin-film photovoltaic conversion device, formed on a substrate, preferably made of a flexible plastic, having first and second conductive layers as electrodes, n-type and p-type layers, graded (varizone) band gap layer including pure silicon and silicon in chemical compositions selected from a group, consisting of SiₓGe₁₋ₓ, SiₓC_{y}, SiₓN_{y} and SiₓO_{y}N₂, all these chemical compositions being simultaneously comprised in graded band gap layer and smoothly changing from one to the other. The photovoltaic device additionally comprises reflective layer, an anti-reflective layer and a protective laminating layer.

JP2005150242A provides a method of manufacturing a high-quality and low-price solar cell substrate having an uneven structure on the surface thereof even when it has a large area, and also to provide a solar cell substrate obtained by the method and a solar cell including the solar cell substrate. The method of manufacturing the solar cell substrate includes a synthetic resin sheet as a structural element; the uneven structure is formed on the surface of the synthetic resin sheet by thermally pressurizing a porous material to the synthetic resin sheet and then peeling the porous material.

US4514581A discloses improvements in solar cells based upon low cost semiconductors, such as amorphous silicon. The improved solar cells of US4514581A have ultrathin active semiconductor layers having a thickness between 0.1 t alpha and Lm wherein t alpha is the solar spectrum absorption length and Lm is the diffusion length for photo generated minority charge carriers in the active layer. The back surface reflector has a solar spectrum reflectivity of 70% or greater, so that incident energy not absorbed in a direct pass through the active layer is reflected for another pass. The most preferred embodiment of the cells described herein is shaped to have a light-trapping structure so that light makes multiple passes through the thin semiconductor layers.

### Object of the Invention

On this background the invention has for its purpose to provide a transducer, which is provided in an elastic or compliant manner, such that the field of application of the transducer in practice may be considerably increased, and such that it is possible to attach the transducer to various surfaces and possibly varying shapes.

### Description of the Invention

The transducer according to the invention is characterized in that said substrate is constituted by a flexible, elastic web or foil, that a front side of said substrate has a three-dimensional surface pattern of raised and depressed surface portions formed therein, said photo electric active (photovoltaic) layer being deposited onto said three-dimensional surface pattern, that said front side electrode and rear side electrode are constituted by electric conductive layers, which comprise electric conductive materials, or which is provided with an electric conductive coatings.

Hereby is in a simple manner achieved an improved transducer, which is flexible and elastic, and which in addition provides the flexible transducer with very important elastic or compliant properties and increase the general area of use of the transducer significantly.

Furthermore, the elastic or compliant properties of the transducer makes it possible to attach the transducer to surfaces of various shapes, by way of example curved surfaces, even double curved surfaces.

It is also possible to attach the transducer to a surface having a shape which varies over time, by way of example due to environmental factors, such as changes in temperature, changes in moisture level, vibrations, shock, etc. Since the compliant properties of the transducer allows it to follow such changes in shape of the surface having the transducer attached thereto, it is prevented that such changes causes damage to the transducer, by way of example in the form of cracks, fractures or tension, and the lifetime of the solar cell may thereby be prolonged.

The substrate may be constituted by a polymer elastomer web or foil. Elastomer materials are known to have compliant properties.

The transducer according to the invention is provided such that the substrate is constituted by a silicone web or foil. Thereby is obtained a transducer having a decreased weight as compared to transducers having a substrate made from a glass material or a metal, such as steel.

Furthermore, the lifetime of the transducer is increased, because silicone is long-time stable with respect to solar light, and since the compliancy of the silicone web or foil is adapted to prevent transfer of mechanical tensions to the active layer in case of temperature variations or other mechanical effects. Finally, the manufacturing costs can be minimised because all process steps can be performed in an inline roll-to-roll process, and because the electrical connections between a pluralities of cells in a solar panel can be deposited directly onto the substrate.

As an alternative, not part of the invention, the substrate may be constituted by a polyurethane web or foil. Polyurethane is a relative cheap material, and polyurethane is furthermore easy to work with, because it relatively quickly achieves a stable, durable state.

The transducer comprises a foremost protecting layer, arranged to protect the active parts of the transducer from wear and tear, as well as impacts caused by the weather. Appropriately, the transducer according to the invention is furthermore provided such that said possible protecting layer is constituted by transparent, elastic or compliant silicone web or foil.

A transducer according to the invention in the form of a flexible, elastic solar cell having a foremost protecting layer, which is constituted by a transparent, flexible silicone web or foil would be appropriate for mounting onto a transparent surface such as a window pane.

In order to further improve the elasticity as well as the efficiency the transducer according to the invention is provided such that the front side of said substrate is provided with a surface pattern of raised and depressed surface portions onto which said photo electric active (photovoltaic) layer being deposited. It is an advantage that the raised and depressed surface portions are formed directly as a surface pattern on the substrate, rather than being formed by pre-straining or compressing the substrate or the transducer, because it is easier to control the direction of compliance, and because it is possible to design and control the pattern, including the size and shape of the raised and depressed surface pattern, in a very accurate manner. Thereby the properties of the transducer can be controlled and designed as desired.

The photo electric active (photovoltaic) layer may be in the form of a silicon compound, by way of example comprising amorphous or crystalline silicon.

More specific the transducer according to the invention may be provided such that said surface pattern comprises waves forming troughs and crests extending essentially in one common direction, each wave defining a height being a shortest distance between a crest and neighbouring troughs. According to this embodiment, the surface pattern provides compliance of the substrate along one direction, while the substrate is substantially stiff along a direction being substantially perpendicular to the compliant direction. Thus, the waves define an anisotropic characteristic facilitating movement in a direction which is perpendicular to the common direction. According to this embodiment, the crests and troughs resemble standing waves with essentially parallel wave fronts.

However, the waves are not necessarily sinusoidal, but could have any suitable shape as long as crests and troughs are defined. According to this embodiment a crest (or a trough) will define substantially linear contour-lines, i.e. lines along a portion of the corrugation with equal height relative to the substrate in general. This at least substantially linear line will be at least substantially parallel to similar contour lines formed by other crest and troughs, and the directions of the at least substantially linear lines define the common direction. The common direction defined in this manner has the consequence that anisotropy occurs, and that movement of the transducer in a direction perpendicular to the common direction is facilitated, i.e. the transducer, or at least a photo electric active layer arranged on the corrugated surface, is compliant in a direction perpendicular to the common direction. As a consequence, the transducer can be attached to a curved surface without introducing cracks or creases in the transducer, because the transducer is capable of stretching and/or compressing along the compliant direction to follow the curves of the surface.

The photo electric active (photovoltaic) layer may be provided with a photo electric active coating in the form of a silicon compound, by way of example comprising amorphous or crystalline silicon.

As an alternative, the surface pattern may comprise waves forming troughs and crest extending essentially in at least two directions along the surface of the substrate. According to this embodiment, the substrate is compliant, and thereby stretchable, along at least two directions. As a consequence, it is possible to attach the transducer to a double curved surface without introducing cracks or creases in the transducer, since the transducer is capable of stretching along the two compliant directions. Thereby it is possible to attach the transducer to a large variety of different kinds of surfaces, such as cars or other vehicles, clothing, sports equipment, facades of buildings, etc. It is even possible to attach the transducer to a surface which changes shape over time.

According to one embodiment, the surface pattern may comprise waves forming troughs and crests, said troughs and crests defining wave fronts extending essentially in at least two directions along the surface of the substrate. Thus, according to this embodiment, the surface pattern comprises crests similar to hilltops, the hilltops being arranged on the surface in such a manner that substantially parallel lines can be drawn between groups of neighbouring hilltops, the parallel lines defining wave fronts. Such wave fronts are defined along at least two directions along the surface of the substrate, e.g. along two directions arranged substantially perpendicularly to each other, or along three directions arranged with a mutual angle of approximately 120°. Accordingly, similarly to what is described above, the substrate is in this case compliant along at least two directions, i.e. the directions defined by the extension of the wave fronts, and the substrate carrying the transducer can thereby be attached to double curved surfaces as described above.

The surface pattern may define a plurality of funnels, each funnel defining interior wall parts arranged relative to each other in such a manner that light incident on an interior wall part of a funnel is reflected onto another interior wall part of said funnel. According to this embodiment the surface pattern is designed in such a manner that it provides so-called "light-trapping". Thereby it can be ensured that light with various angles of incidence will reach the photo electric active (photovoltaic) layer. Furthermore, it is ensured that the part of the incident light which is reflected from an interior wall part reaches another interior wall part, i.e. the reflected light also reaches the photo electric active (photovoltaic) layer, possibly multiple times. Thereby the efficiency of the transducer is significantly increased.

The interior wall parts may advantageously be arranged in such a manner that they define an angle there between, the angle being smaller than 60°, such as smaller than 50°, such as smaller than 40°.

The funnels may advantageously be provided as microstructures, as nanostructures or as a combination of microstructures and nanostructures.

In general the transducer according to the invention is provided such that said photo electric active layer has a shape which is formed by the said surface pattern of the substrate. To enable elongation of the transducer in one or more directions, i.e. to provide compliance, the photo electric active layer preferably has a corrugated shape which renders the area of the photo electric active layer larger than the area occupied by the transducer in a relaxed state.

The corrugated shape of the photo electric active layer thereby facilitates that the transducer can be stretched and/or compressed to follow the shape of a surface onto which the transducer is mounted, without having to stretch the photo electric active layer, but merely by evening out the corrugated shape of the photo electric active layer. According to this embodiment, the corrugated shape of the photo electric active layer is a replica of the surface pattern of the substrate.

The transducer may advantageously be a solar cell. In this case the transducer according to the invention may furthermore be such provided that the solar cell comprises a photovoltaic part and a thermoelectric part arranged adjacent to each other.

Preferably, in this embodiment the transducers may be such provided that the photovoltaic part is arranged in a foremost position and the thermoelectric part is arranged in a rearmost position. It is common that part of the energy received by a solar cell from incoming sun light is deposited in the form of heat in the solar cell, rather than being transformed into electricity. Apart from the fact that this heat may be detrimental to the solar cell, it also represents an energy loss in the system. By arranging a photovoltaic part in a foremost position and a thermoelectric part in a rearmost position, it is obtained that the photovoltaic part initially transforms a part of the incident light into electricity. Subsequently, the thermoelectric part transforms at least part of the heat deposited in the solar cell into electricity. Thereby the total yield of the solar cell is increased.

In another embodiment of the invention, the transducer is a light emitting device. In this embodiment a voltage is applied to the electric conductive terminals on the rear side and the front side, which will reverse the function of the transducer to emit photons hence light.

Given the three-dimensional surface pattern of raised and depressed surface portions formed, the surface serves as a light emitter from which the photons will escape the "light-trap" in an opposite direction compared to the capture of light when the transducer is working as a solar cell.

Having a randomly formed surface, the light will escape in a diffuse way suitable for creating a subtle lighting element ideal for providing say a luminescent layer. If given an orderly formed surface, the light will escape in an orderly predetermined manner.

It should be noted that the present invention covers transducers operating purely as solar cells, transducers operating purely as light emitting devices as well as transducers which are capable of operating as a solar cell as well as a light emitting device.

### Description of the Drawing

The invention is described in more detail with reference to the drawing, in which:
- Fig. 1: shows a plane sectional view of an embodiment of a solar cell according to the invention build up on a silicone web or foil,
- Fig. 2: shows a perspective view of the solar cell cf. Fig. 1 - as seen from above,
- Fig. 3: shows a plane view - partly in section - of another embodiment of a solar cell according to the invention build up on a silicone foil or web and with a protecting silicone foil on the front side,
- Fig. 4: shows a perspective view of the solar cell cf. Fig. 3 - as seen from above,
- Fig. 5: shows a plane view of a rolled up transducer to the left hand side in top of Fig. 5, to the right hand side an enlarged view of the upper surface of the transducer, while a lower sectional view shows the different layers of the transducer,
- Fig. 6: shows a perspective view of an embodiment of the corrugation of the front surface of a substrate of a transducer according to the invention,
- Fig. 7: shows a plane sectional view of an embodiment of a transducer in the form of a combined solar cell and thermoelectric cell according to the invention,
- Fig. 8: shows a plane sectional view illustrating "light trapping" of light beams between the waves of the corrugated surface of the substrate of a transducer in the form of a solar cell according to the invention,
- Fig. 9: shows a perspective view of another embodiment of the corrugation of the front surface of a substrate of a solar cell according to the invention,
- Fig. 10: shows a perspective view illustrating a possible surface pattern of the front surface of a substrate for a solar cell according to the invention, and
- Fig. 11: shows a 3D view of a piece of an embodiment of solar cell according to the invention - illustrating the flexibility as well as the elasticity of the substrate in the form of a silicone web or foil.

### Detailed Description of the Invention

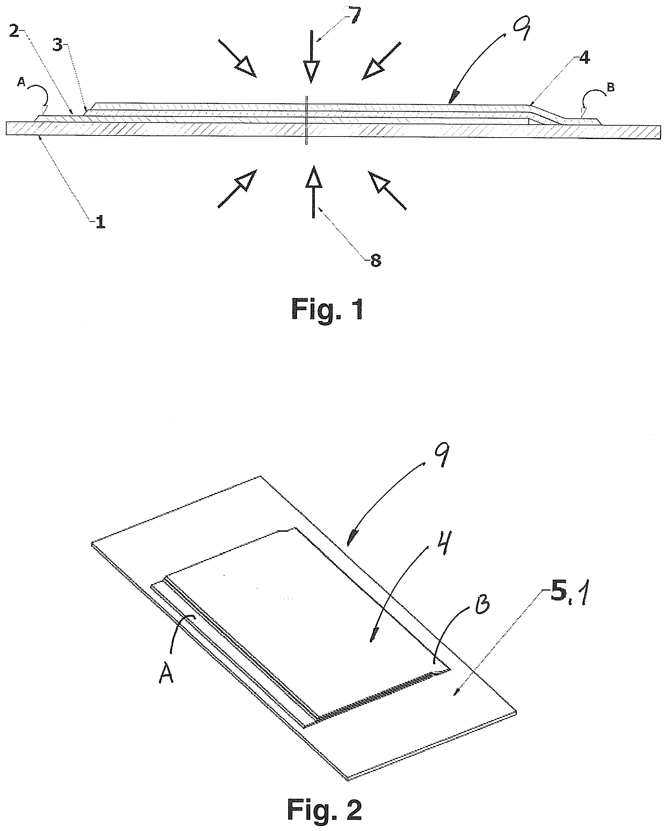

The transducer 9 shown in Figs 1 and 2 is built up on a substrate or carrying material in the form of a silicone web or foil 1, 5. On top of the silicone web or foil 1, 5 is deposited a rear side electrode 2, A in the form of an electric conductive layer in the form of a layer of silver (Ag) deposited by DC-sputtering in an argon (Ar) atmosphere.

By RF-/DC-sputtering is then deposited one or more group of layers each consisting of a n-Si layer, a i-Si layer and a p-Si layer constituting the photo electric active layer 3 to the surface pattern of the front side of said substrate in an atmosphere of argon/hydrogen (Ar/H2). The photovoltaic layer 3 may very often comprise up to three or more groups of n-Si, i-Si and p-Si layers.

Afterwards is by RF-sputtering deposited a front side electrode 4, B either in the form of a layer of indium tin oxide (ITO) or in the form of a layer of zinc oxide (ZnO₂) in both cases in an argon/oxygen (Ar/O₂) atmosphere. The in-coming light to the transducer 9, is indicated by arrows 7, while arrows 8 at the opposite side of the solar cells 9, indicate a possible view out through the solar cell. In case the silicone substrate of the transducer 9 is transparent, then also the whole transducer 9 may be transparent.

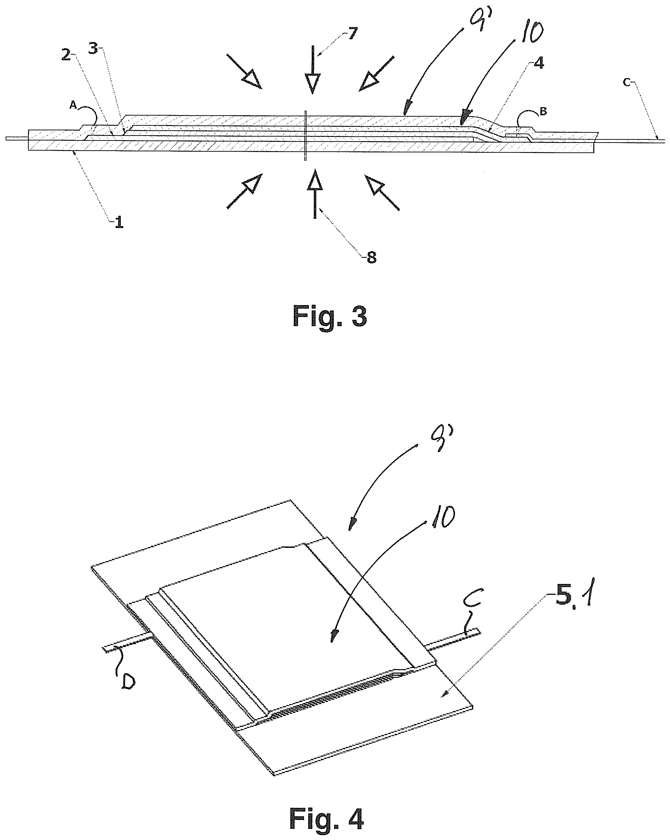

By the transducer 9' shown in Figs. 3 and 4 most of the above described items are the same as the items of the solar cell 9 cf. Figs. 1 and 2 and the same reference numerals are used for identical items. However, the transducer 9' shown in Figs, 3 and 4 comprises a further upper protective layer 10 in the form of a possible transparent silicone web or foil 10. Additionally, the transducer 9' shown in Figs. 3 and 4 comprise an electric conductive terminal D connected to the rear side electrode 2, A and an electric conductive terminal C connected to the front side electrode 4, B.

Possibly the shown transducers 9, 9'may furthermore comprise a not shown upper anti reflective layer (ARC) deposited to the upper surface of the transducers 9, 9' in an argon (Ar) atmosphere.

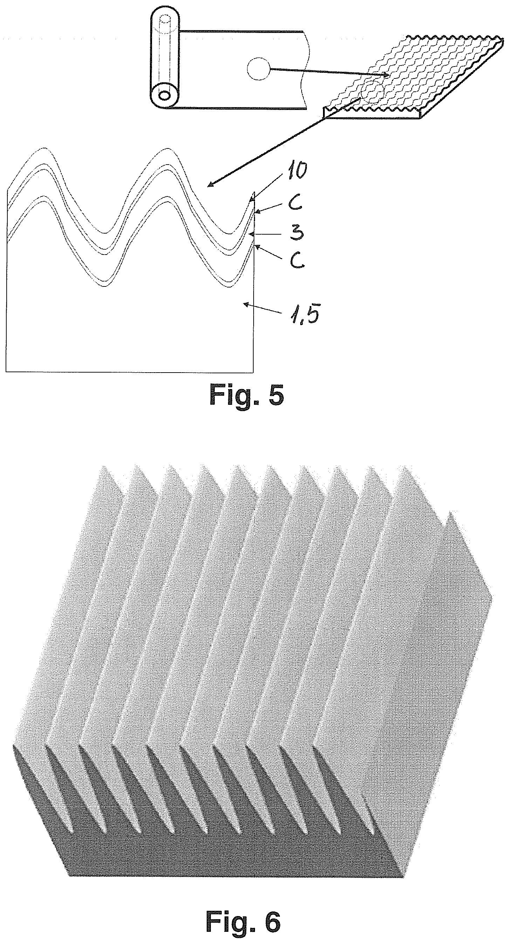

In three steps Fig. 5 shows a plane view of a rolled up transducer according to the invention in the left hand side in the upper part of Fig. 5, to the right hand side is shown an enlarged perspective view of the corrugated upper surface of the substrate of the transducer, while a lower further enlarged sectional view shows the different layers of the transducer 9', namely an upper protective layer 10, a top electrode C, more electricity generating layers 3 and a coated silicone web or foil 1, 5 with 3D surface structure.

The upper surface of the substrate shown in Fig. 5 is corrugated in two directions along the surface. Thus, it can be seen from Fig. 5 that it is possible to draw parallel lines between neighbouring crests or hilltops along a longitudinal direction of the substrate as well as along a transversal direction of the substrate. Accordingly, the solar cell is compliant in two directions, and it can thereby be stretched and/or compressed to fit surfaces of various shapes, such as double curved surfaces, as described above.

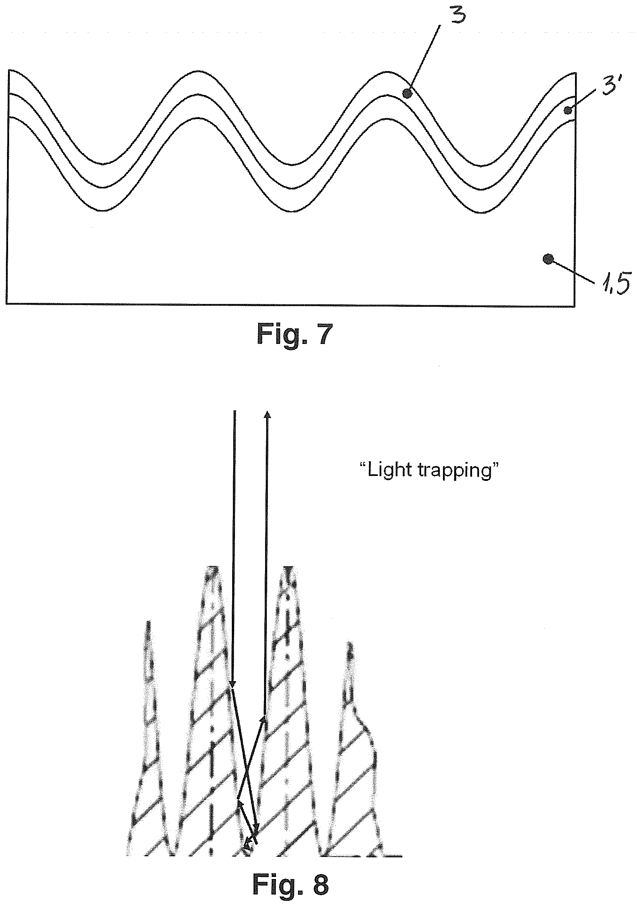

Figs. 6 and 7 show in a highly enlarged scale an embodiment of a transducer substrate according to the invention in the form of a silicone web having 3D surface structure with uniformed straight waves. The transducer substrate shown in Figs. 6 and 7 is provided with a surface pattern of raised and depressed surface portions in the form of waves forming troughs and crests extending essentially in one common direction. Thus, the transducer substrate of Figs. 6 and 7 is compliant along a direction which is substantially perpendicular to the direction defined by the wave fronts, i.e. along a longitudinal direction of the substrate. The transducer substrate is relatively stiff along the direction defined by the wave fronts. Thereby the transducer can be stretched in the compliant direction, but not in the transversal direction.

Fig. 8 shows in a highly enlarged scale the situation called "light trapping" where an incoming light beam is reflected several times on the corrugated (waved) surface of a substrate of a solar cell and finally is possibly residual light thrown back from the solar cell. Such "light trapping" in the surface of a transducer may cause an improvement of the efficiency of the transducer.

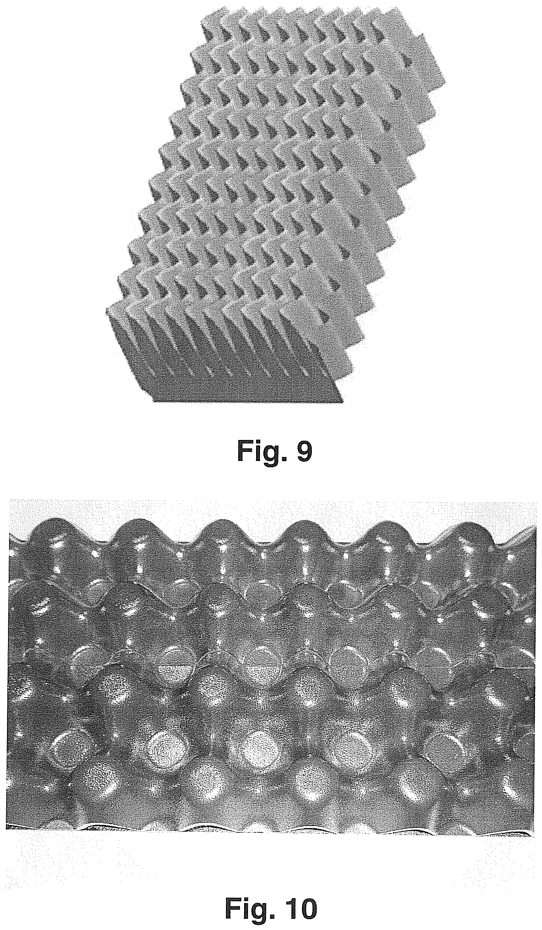

Fig. 9 shows in a highly enlarged scale a further embodiment of a transducer substrate according to the invention in the form of a silicone web having a 3D surface structure with uniform waves with corrugations in more directions. Hereby the active surface of the solar cell may be significantly enlarged in order to improve the efficiency of the transducer.

Furthermore, the transducer substrate is compliant in a longitudinal direction as well as in a transversal direction. Thereby the transducer is stretchable in both of these directions, and it is therefore possible to mount the transducer on a large variety of different surfaces, such as double curved surfaces by way of example concave or convex surfaces without risking to introduce cracks or creases in the substrate.

Furthermore, since the photo electric active layer is coated onto the substrate in such a manner that it adopts the shape of the surface pattern, the photo electric active layer will simply move along with the surface of the substrate when it is stretched and/or compressed, and thereby no stress is introduced in the photo electric active layer.

Fig. 10 shows in a highly enlarged scale a still further embodiment of the surface of a transducer substrate according to the invention in the form of a silicone web having a great number of blunt peaks and valleys (similar to an egg tray) in order to enlarge the surface area and thereby improve the efficiency of the transducer. Furthermore this embodiment of the surface of the transducer may cause an improved efficiency by the fact that incoming solar light from different directions may hit the inclined sides of the blunt peaks as well as the bottom surfaces of the valleys. Furthermore, in the surface pattern shown in Fig. 10 it is possible to draw parallel lines between neighbouring peaks along at least three different directions along the surface of the substrate. Accordingly, the substrate shown in Fig. 10 is compliant in at least three directions.

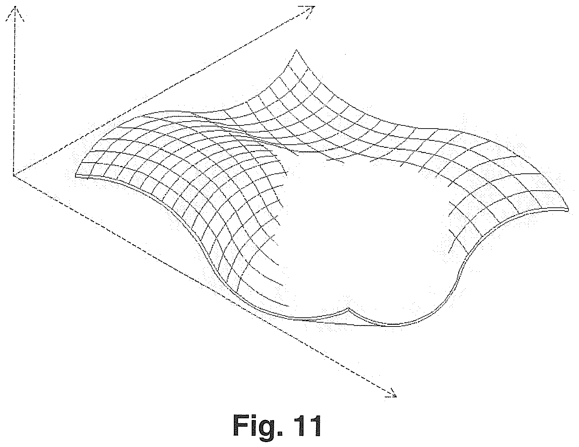

Fig. 11 shows a perspective, 3D view of a piece of an embodiment of a transducer having a silicone substrate according to the invention - and illustrating the flexibility as well as the elasticity of the silicone substrate of the transducer. The elasticity together with the flexibility is very important features in order to make it possible to durably mount the transducer on complex surfaces comprising inwards bending (concave) as well as outwards bending (convex) surface parts.

As described above, the silicone substrate in itself possesses elastic properties allowing the substrate to be stretched to some extent. However, providing the surface of the silicone substrate with a surface pattern defining troughs and crests along one, two or more directions significantly enhances the elastic properties of the substrate. It should be noted that the elasticity of the transducer renders the transducer robust with respect to changes in the dimensions and/or shape of a surface having the transducer attached thereto, since the elasticity of the transducer allows it to change its shape to follow the changes in the mounting surface. This prolongs the expected lifetime of the transducer and allows it to be attached to an even larger variety of different kinds of surfaces. Changes in the dimensions and/or shape of a surface having the transducer attached thereto may by way of example be caused by environmental influences, such as changes in temperature, changes in moisture level, vibrations, shocks, etc.

The rear side electrode and the top side electrode of the transducer according to the invention of course have to be connected with an electric controlling circuit or other electric devices in a proper manner by way of example by means of contact portions or connectors as describes in WO 2008/052559 A2 page 50, line 21 - page 53, line 6 and in Figs. 23-36.

By the preferred method of the production of the transducer according to the invention a silicone substrate is forwarded with said front side facing upwards supported on a top course of an endless conveyor or a similar transportation unit in successive order through the following treatment stations:
- in a first treatment station providing said surface pattern of the front side of said substrate with a plasma treating in an argon (Ar) atmosphere,
- in a second treatment station applying by DC-sputtering a rear side electrode in the form of a layer of silver (Ag) in an argon (Ar) atmosphere,
- in a third treatment station applying by RF-/DC-sputtering one or more group of layers each consisting of a n-Si layer, a i-Si layer and a p-Si layer to said surface pattern of the front side of said substrate in an atmosphere of argon/hydrogen (Ar/H₂),
- in a fourth treatment station applying by RF-sputtering a front side electrode either in the form of a layer of indium tin oxide (ITO) or in the form of a layer of zinc oxide (ZnO₂) in both cases in an argon/oxygen (Ar/O₂) atmosphere,
- in a possible fifth treatment station applying an anti reflective (ARC) layer in an argon (Ar) atmosphere, and
- in a final treatment station, at the end of the endless belt conveyor, rolling up the finished transducer.

By said surface treatment in said first treatment station microscopic quartz crystals (SiO₂) or other quarts grains/structures are formed on the front side surface of the silicone substrate by way of example by reconstructing or transforming residual compounds and/or depositing of supplementary compounds. Thereby the adherence of front side surface is significant improved for the subsequent application of further layers onto the front surface of the front side surface of the silicone substrate.

In said third treatment station is by RF-/DC-sputtering in an argon atmosphere typically built up a number of groups of at least three layers (p-Si layer, i-Si layer and n-Si layer) constituting the active electricity generating layer of the transducer, which is positioned on or between one or more layers of a silicone based web/foil or other geometric shape.

The three layers (or more) of the active layer of the solar cell consist respectively of a top electrode, which is transparent and electric conductive (TCO - Transparent Conductive Oxide), the photo active (photovoltaic) layer, and the electric conductive rear side electrode, which may be transparent or partly transparent or not transparent at all.

The active layer of the transducer is coated on or joint with a substrate consisting of a silicone based polymer or elastomer - all polymers or elastomer comprising a silicon compound may be used.

The silicone substrate of the solar cell may be (but not necessarily) provided with fibres or other reinforcing elements, which increases the tensile strength and thereby the lifetime and makes the mounting easier.

The silicone substrate of the solar cell may be (but not necessarily) laminated or in another way joint together with another flexible or not flexible substrate in order to increase the tensile strength. Such increased tensile strength may be advantageous during the production, during the mounting, as well as during the use of the solar cell.

The primary purposes of the present invention can be listed as follows:
- to provide a solar cell on a silicone containing polymer (elastomer) substrate, web or foil;
- to form a photovoltaic cell module on a silicone based carrying material/substrate;
- to form a solar cell, which basically is flexible and elastic;
- to form a solar cell, which basically in its flexible and elastic form may be mounted on a rigid surface or carrier, which reduces or removes this flexibility/elasticity.

Furthermore the solar cell may be a combination of a photovoltaic solar cell layer 3, which is positioned in a foremost position and a thermo electric transducer layer 3' positioned in a rearmost position (Fig. 7). The thermoelectric transducer layer 3' takes up the thermal energy, which is not taken up by photovoltaic solar cell layer 3, which is positioned at the front side.

Thermoelectric transducers rely on the Seebeck and Peltier effects to convert heat into electrical power. Transducer performance can be summarized using two specifications, the thermodynamic efficiency (the ratio of power generated to power drawn from a heat source) and the power density (the power generated per unit area of the device). These metrics depend on the materials used in the thermoelectric transducer couple, the temperatures of the hot and cold sides of the transducer, and the load driven by the transducer.

The solar cell may consist of p-i-n type conductive layers of correct endowed amorphous hydrogen based silicon. Amorphous silicon absorbs about 40 times more efficiently than that of crystalline silicon. As TCO layer is in the first round used indium tin oxide (ITO). In order to increase the effect of the solar cell an anti reflective coating (ARC) may be applied. The temperature of the substrate shall be lowest possible, by way of example in the range of 100° - 400° C, preferably in the range of 150° - 250° C, as it otherwise would be impossible afterwards to deposit on a flexible polymer substrate.

It should be possible to deposit the individual layers by reactive RF-/DC-sputtering in an Ar/H₂ atmosphere. Hydrogen is added in order to fill out the present "dangling bonds" in the amorphous silicon layer, as these otherwise will function as electron traps and lower the efficiency.

**p-i-n-type layers:**

| | | |
|---|---|---|
| p-Si layer: | Thickness abt. 8 nm | DC-sputtering rate = 3,5- 9 nm/min |
| i-Si layer: | Thickness abt. 400-500 nm | RF-sputtering rate = 7-8 nm/min |
| n-Si layer: | Thickness abt. 20 nm | DC-sputtering rate = 3-10 nm/min |

### Depositing of layers:

- Usually the metal layers (by way of example the rear side electrode) will be deposited by DC-sputtering.
- Usually metal oxides (by way of example the front side electrode, the TCO layer) will be deposited by RF-sputtering - however CVD and PECVD would also be possible.
- n-Si and p-Si layers can be deposited by DC-sputtering, but will more likely be deposited by RF-sputtering - however CVD and PECVD would also be possible.
- i-Si (the thick Si layer) can be deposited by RF-sputtering, PECVD or CVD.

During the depositing by sputtering the temperature of the substrate shall possibly be high (∼ 200°C). Therefore it is very important to be able to control the temperature of the substrate during the depositing/sputtering.

A production of a transducer according to the form of a solar cell on a substrate in the form of a preferably silicone web or foil, may be characterized in carrying said silicone web or foil with said front side facing upwards supported on a top course of an endless conveyor or a similar transportation unit in successive order through the following treatment stations:
- in a first treatment station providing said surface pattern of the front side of said substrate with a plasma treating in an argon (Ar) atmosphere,
- in a second treatment station applying by RF-/DC-sputtering a rear side electrode an electric conductive layer in an argon (Ar) atmosphere,
- in a third treatment station applying by RF-/DC-sputtering one or more group of layers each consisting of a n-Si layer, a i-Si layer and a p-Si layer to said surface pattern of the front side of said substrate in an atmosphere of argon/hydrogen (Ar/H₂),
- in a fourth treatment station applying by RF-sputtering a front side electrode an electric conductive layer in an argon/oxygen (Ar/O₂) atmosphere,
- in a possible fifth treatment station applying an anti reflective (ARC) layer in an argon (Ar) atmosphere, and
- in a final treatment station, at the end of the endless belt conveyor, rolling up the finished solar cell.

Hereby is achieved a quite new and improved method for the production of not just flexible but also elastic solar cells with a possible length from 20 mm to 20000 mm or more and a width from 100 mm to 1500 mm, e.g. approximately 500 mm. In other words the new and inventive solar cells may be provided in rolls with a length as required by the customers. Of course the width and the length of the solar cell may be further adapted in accordance with specific customer orders.

The surface pattern of the front side of the silicone substrate causes a very significant increase of the area of the photovoltaic (electricity generating) layer of the solar cell, which means a similar significant increase of the efficiency of the solar cell according to the invention.

A very important further advantage is the economical side of the invention because also the production price and as a consequence also the sales price of the solar cells per area unit may be considerably minimized.

More specific the method of the production of a transducer in accordance to the invention may be characterized in carrying said silicone web or foil with said front side facing upwards supported on a top course of an endless conveyor or a similar transportation unit in successive order through the following treatment stations:
- in a first treatment station providing said surface pattern of the front side of said substrate with a plasma treating in an argon (Ar) atmosphere,
- in a second treatment station applying by DC-sputtering a rear side electrode in the form of a layer of silver (Ag) in an argon (Ar) atmosphere,
- in a third treatment station applying by RF-/DC-sputtering one or more group of layers each consisting of a n-Si layer, a i-Si layer and a p-Si layer to said surface pattern of the front side of said substrate in an atmosphere of argon/hydrogen (Ar/H₂),
- in a fourth treatment station applying by RF-sputtering a front side electrode either in the form of a layer of indium tin oxide (ITO) or in the form of a layer of zinc oxide (ZnO₂) in both cases in an argon/oxygen (Ar/O₂) atmosphere,
- in a possible fifth treatment station applying an anti reflective (ARC) layer in an argon (Ar) atmosphere, and
- in a final treatment station, at the end of the endless belt conveyor, rolling up the finished solar cell.

It should be mentioned, that in another embodiment of the invention, the transducer is a light emitting device.

In this embodiment a voltage is applied to the electric conductive terminals on the rear side and the front side, which will reverse the function of the transducer to emit photons hence light.

Given the three-dimensional surface pattern of raised and depressed surface portions formed, the surface serves as a light emitter from which the photons will escape the "light-trap" in an opposite direction compared to the capture of light when the transducer is working as a solar cell.

Having a randomly formed surface, the light will escape in a diffuse way suitable for creating a subtle lighting element ideal for providing say a luminescent layer. If given an orderly formed surface, the light will escape in an orderly predetermined manner.

Finally, it should furthermore be mentioned that a transducer according to the invention in the form of a solar cell mounted on a specific surface could be combined with a transducer according to the invention in the form of a light emitting device, where the latter could possible form a light advertising sign as a fitted in part of by way example the front surface of a building being mounted with a transducer in the form of a solar cell according to the invention as well.

### Technical terms:

- PV:: Photovoltaic
- RF:: Radio Frequency
- DC:: Direct Current
- ARC:: Anti Reflective Coating
- TCO:: Transparent Conductive Oxide
- PVD:: Physical Vapour Deposition
- CVD:: Chemical Vapour Deposition
- PECVD:: Plasma Enhanced Chemical Vapour Deposition

### Drawing reference numbers:

- 1:: Substrate (silicone foil or web, carrying material)
- 2:: Rear side electrode (connector)
- 3:: Photo electric active (photovoltaic) layer (electricity generating layer)
- 4:: Front side electrode (connector)
- 5:: Substrate (silicone foil or web)
- 7:: Solar light (incoming solar light)
- 8:: Vision through the solar cell (front side and rear side electrodes are transparent)
- 9:: Transducer (solar cell)
- 10:: Upper protective layer (possibly transparent)
- A:: Rear side electrode (terminal/connector)
- B:: Front side electrode (terminal/connector)
- C:: Front side electrode (terminal/connector)
- D:: Rear side electrode (terminal/connector)

## Claims

1. A photoelectric transducer comprising:
a substrate (1, 5) constituted by a flexible elastic web or foil, the substrate including a planar rear surface and a front surface with a surface pattern of a plurality of repeating raised and depressed surface portions which extend in at least one direction; thereon a rear side electrode (2, A) provided on the front surface of the substrate and conforming in shape to the front surface of the substrate; thereon
a photoelectric active layer (3) conforming in shape to the front surface of the substrate and having the pattern of repeating raised and depressed surface portions which extend in the at least one direction and with an area of the front facing surface of the photoelectric active layer that is larger than the surface area occupied by the rear smooth surface of the substrate in a relaxed state; thereon
a front side electrode (4, B) provided on a front surface of the photoelectric active layer; thereon
a front protection layer comprising a transparent, elastic silicone web or foil provided above the upper surface of the photoelectric active layer;
where the photoelectric active layer (3) is less stretchable and less compressible than the substrate (1, 5), thereby allowing the substrate (1, 5) to change shape while maintaining the area of the front surface of the photoelectric transducer, wherein said substrate (1, 5) is constituted by a silicone web or foil and the front surface of the substrate is an argon plasma treated front surface having microscopic quartz crystals (SiO₂) or other quartz grains/structures.

2. Photoelectric transducer according to any of the preceding claims, ***characterized in* that** said photoelectric active (photovoltaic) layer (3) is constituted by a photoelectric active coating in the form of a silicon compound comprising amorphous or crystalline silicon.

3. Photoelectric transducer according to any of the preceding claims, ***characterized in* that** said surface pattern comprises waves forming troughs and crests extending in one common direction, each wave defining a height being a shortest distance between a crest and neighbouring troughs.

4. Photoelectric transducer according to any of the preceding claims, ***characterized in* that** said surface pattern comprises waves forming troughs and crests, said troughs and crests defining wave fronts extending in at least two directions along the surface of the substrate.

5. Photoelectric transducer according to claim 3 or 4, ***characterized in* that** the waves have wavelengths in the same order of magnitude as the amplitude of the surface pattern.

6. Photoelectric transducer according to any of the preceding claims, ***characterized in* that** the photoelectric active layer has a thickness in the order of 500 nm.

7. Photoelectric transducer according to any of the preceding claims, ***characterized in* that** the photoelectric transducer is a solar cell.

8. Photoelectric transducer according to claim 7, ***characterized in* that** the solar cell comprises a photovoltaic part and a thermoelectric part arranged adjacent to each other.

9. Photoelectric transducer according to claim 8, ***characterized in* that** the photovoltaic part is arranged in a foremost position and the thermoelectric part is arranged in a rearmost position.

10. Photoelectric transducer according to any of claims 1-6, ***characterized in* that** the photoelectric transducer is a light emitting device.

## Patentansprüche

1. Photoelektrischer Wandler, umfassend:
ein Substrat (1, 5), das aus einem flexiblen elastischen Gewebe oder einer flexiblen elastischen Folie besteht, wobei das Substrat eine plane Rückfläche und eine Stirnfläche mit einem Oberflächenmuster aus einer Vielzahl von sich wiederholenden erhabenen und vertieften Oberflächenabschnitten, die sich in mindestens einer Richtung erstrecken, beinhaltet; darauf ein Rückseitenelektrode (2, A), die an der Stirnfläche des Substrats bereitgestellt ist und sich der Form nach an die Stirnfläche des Substrats anpasst; darauf
eine photoelektrische aktive Schicht (3), die sich der Form nach der Stirnfläche des Substrats anpasst und das Muster der sich wiederholenden erhabenen und vertieften Oberflächenabschnitte aufweist, die sich in der mindestens einen Richtung erstrecken, und wobei eine Fläche der nach vorne weisenden Oberfläche der photoelektrischen aktiven Schicht in einem entspannten Zustand größer als die Oberfläche ist, die von der rückwärtigen glatten Oberfläche des Substrats eingenommen wird; darauf
eine Vorderseitenelektrode (4, B), die an einer Stirnfläche der photoelektrischen aktiven Schicht bereitgestellt ist; darauf
eine vordere Schutzschicht, die ein transparentes, elastisches Silikongewebe oder eine transparente, elastische Silikonfolie umfasst, das/die über der oberen Fläche der photoelektrischen aktiven Schicht bereitgestellt wird;
wobei die photoelektrische aktive Schicht (3) weniger dehnbar und weniger komprimierbar als das Substrat (1, 5) ist, wodurch es dem Substrat (1, 5) ermöglicht wird, die Form zu verändern, während die Fläche der Stirnfläche des photoelektrischen Wandlers aufrechterhalten wird, wobei das Substrat (1, 5) aus einem Silikongewebe oder einer Silikonfolie besteht und die Stirnfläche des Substrats eine mit Argonplasma behandelte Stirnfläche ist, die mikroskopische Quarzkristalle (SiO₂) oder andere Quarzkörner/-strukturen aufweist.

2. Photoelektrischer Wandler nach einem der vorstehenden Ansprüche, **dadurch gekennzeichnet, dass** die photoelektrische aktive (photovoltaische) Schicht (3) aus einer photoelektrischen aktiven Beschichtung in der Form einer Siliciumverbindung, die amorphes oder kristallines Silicium umfasst, besteht.

3. Photoelektrischer Wandler nach einem der vorstehenden Ansprüche, **dadurch gekennzeichnet, dass** das Oberflächenmuster Wellen umfasst, die Täler und Berge bilden, die in eine gemeinsame Richtung verlaufen, wobei jede Welle eine Höhe definiert, die ein kürzester Abstand zwischen einem Berg und den benachbarten Tälern ist.

4. Photoelektrischer Wandler nach einem der vorstehenden Ansprüche, **dadurch gekennzeichnet, dass** das Oberflächenmuster Wellen umfasst, die Täler und Berge bilden, wobei die Täler und Berge Wellenfronten definieren, die in mindestens zwei Richtungen entlang der Oberfläche des Substrats verlaufen.

5. Photoelektrischer Wandler nach Anspruch 3 oder 4, **dadurch gekennzeichnet, dass** die Wellen Wellenlängen in derselben Größenordnung wie die Amplitude des Oberflächenmusters aufweisen.

6. Photoelektrischer Wandler nach einem der vorstehenden Ansprüche, **dadurch gekennzeichnet, dass** die photoelektrische aktive Schicht eine Dicke von ungefähr 500 nm aufweist.

7. Photoelektrischer Wandler nach einem der vorstehenden Ansprüche, **dadurch gekennzeichnet, dass** der photoelektrische Wandler eine Solarzelle ist.

8. Photoelektrischer Wandler nach Anspruch 7, **dadurch gekennzeichnet, dass** die Solarzelle einen photovoltaischen Teil und einen thermoelektrischen Teil umfasst, die angrenzend aneinander angeordnet sind.

9. Photoelektrischer Wandler nach Anspruch 8, **dadurch gekennzeichnet, dass** der photovoltaische Teil an einer vordersten Position angeordnet ist und der thermoelektrische Teil an einer hintersten Position angeordnet ist.

10. Photoelektrischer Wandler nach einem der Ansprüche 1-6, **dadurch gekennzeichnet, dass** der photoelektrische Wandler eine lichtemittierende Vorrichtung ist.

## Revendications

1. Transducteur photoélectrique comprenant :
un substrat (1, 5) constitué d'une bande ou d'une feuille élastique flexible, le substrat comportant une surface arrière plane et une surface avant avec un motif de surface d'une pluralité de parties de surface surélevées et renfoncées de répétition qui s'étendent dans au moins une direction ; au-dessus, une électrode côté arrière (2, A) étant prévue sur la surface avant du substrat et dont la forme correspond à la surface avant du substrat ; au-dessus
une couche active photoélectrique (3) dont la forme correspond à la surface avant du substrat et ayant le motif de parties de surface surélevées et renfoncées de répétition qui s'étendent dans l'au moins une direction et avec une zone de la surface avant de la couche active photoélectrique qui est plus grande que la surface occupée par la surface lisse arrière du substrat dans un état détendu ; au-dessus
une électrode côté avant (4, B) étant prévue sur une surface avant de la couche active photoélectrique ; au-dessus, une couche de protection avant comprenant une bande ou une feuille en silicone élastique transparente prévue au-dessus de la surface supérieure de la couche active photoélectrique ;
dans lequel la couche active photoélectrique (3) est moins extensible et moins compressible que le substrat (1, 5), permettant ainsi au substrat (1, 5) de changer de forme tout en maintenant la zone de la surface avant du transducteur photoélectrique, dans lequel ledit substrat (1, 5) est constitué d'une bande ou d'une feuille en silicone et la surface avant du substrat est une surface avant traitée au plasma d'argon ayant des cristaux de quartz microscopiques (SiO₂) ou d'autres grains/structures de quartz.

2. Transducteur photoélectrique selon l'une quelconque des revendications précédentes, **caractérisé en ce que** ladite couche active photoélectrique (photovoltaïque) (3) est constituée d'un revêtement actif photoélectrique sous la forme d'un composé de silicium comprenant du silicium amorphe ou cristallin.

3. Transducteur photoélectrique selon l'une quelconque des revendications précédentes, **caractérisé en ce que** ledit motif de surface comprend des ondes formant des creux et des crêtes s'étendant dans une direction commune, chaque onde définissant une hauteur étant à la distance la plus petite entre une crête et des creux voisins.

4. Transducteur photoélectrique selon l'une quelconque des revendications précédentes, **caractérisé en ce que** ledit motif de surface comprend des ondes formant des creux et des crêtes, lesdits creux et crêtes définissant des fronts d'onde s'étendant dans au moins deux directions le long de la surface du substrat.

5. Transducteur photoélectrique selon la revendication 3 ou 4, **caractérisé en ce que** les ondes ont des longueurs d'onde dans le même ordre d'amplitude que l'amplitude du motif de surface.

6. Transducteur photoélectrique selon l'une quelconque des revendications précédentes, **caractérisé en ce que** la couche active photoélectrique a une épaisseur de l'ordre de 500 nm.

7. Transducteur photoélectrique selon l'une quelconque des revendications précédentes, **caractérisé en ce que** le transducteur électrique est une cellule solaire.

8. Transducteur photoélectrique selon la revendication 7, **caractérisé en ce que** la cellule solaire comprend une partie photovoltaïque et une partie thermoélectrique agencées de manière adjacente l'une à l'autre.

9. Transducteur photoélectrique selon la revendication 8, **caractérisé en ce que** la partie photovoltaïque est agencée dans une position la plus en avant et la partie thermoélectrique est agencée dans une position la plus en arrière.

10. Transducteur photoélectrique selon l'une quelconque des revendications 1 à 6, **caractérisé en ce que** le transducteur photoélectrique est un dispositif d'émission de lumière.
